# EUROPÄISCHE PATENTSCHRIFT

(11) **EP 2 635 048 B1**
(45) Veröffentlichungstag und Bekanntmachung des Hinweises auf die Patenterteilung: **17.12.2014**
(21) Anmeldenummer: 13157423.8
(22) Anmeldetag: 01.03.2013
(51) Int. Cl.: H04R 25/00

(54) **Verstärken eines Sprachsignals in Abhängigkeit vom Eingangspegel**
Amplification of a speech signal based on the input level
Amplification d'un signal vocal en fonction du niveau d'entrée

(30) Priorität: 01.03.2012 DE 102012203253
(43) Veröffentlichungstag der Anmeldung: 04.09.2013
(73) Patentinhaber: Siemens Medical Instruments Pte. Ltd., Singapore 139959 (SG)
(72) Erfinder: Giese, Ulrich, 90762 Fürth (DE); Serman, Maja, 91054 Erlangen-Buckenhof (DE)
(74) Vertreter: Maier, Daniel Oliver

(56) Entgegenhaltungen:
- DE-A1-102005 061 000
- US-A1- 2011 137 649

## Beschreibung

Die vorliegende Erfindung betrifft ein Verfahren zum Verstärken eines Sprachsignals für eine Hörvorrichtung durch Erfassen eines Eingangsschalls durch die Hörvorrichtung, Ermitteln eines Eingangspegels des Eingangsschalls und Verstärken des Eingangsschalls durch die Hörvorrichtung. Darüber hinaus betrifft die vorliegende Erfindung eine Hörvorrichtung mit einer Erfassungseinrichtung zum Erfassen eines Eingangsschalls, einer Messeinrichtung zum Ermitteln eines Eingangspegels des Eingangsschalls und einer Verstärkungseinrichtung zum Verstärken des Eingangsschalls. Unter einer Hörvorrichtung wird hier jedes im oder am Ohr tragbare, einen Schallreiz erzeugende Gerät verstanden, insbesondere ein Hörgerät, ein Headset, Kopfhörer und dergleichen.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Hörgerät mit externem Hörer (RIC: receiver in the canal) und In-dem-Ohr-Hörgeräte (IdO), z.B. auch Concha-Hörgeräte oder Kanal-Hörgeräte (ITE, CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

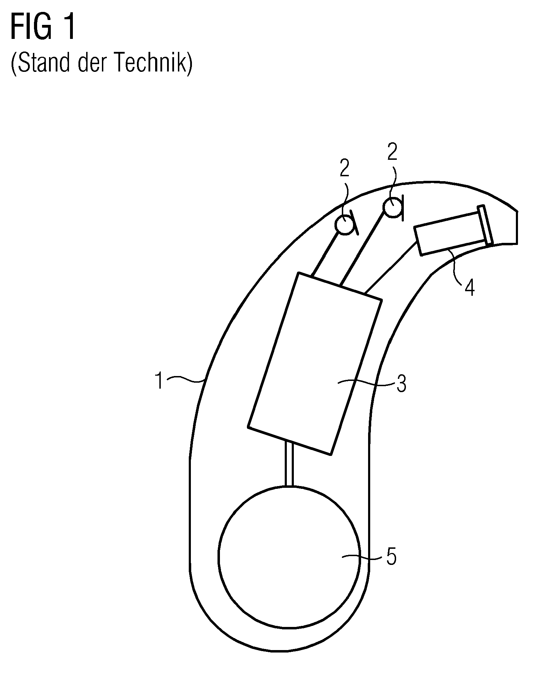

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Energieversorgung des Hörgeräts und insbesondere die der Signalverarbeitungseinheit 3 erfolgt durch eine ebenfalls ins Hörgerätegehäuse 1 integrierte Batterie 5.

Der dynamische Bereich des Hörens ist bei zentraler Hörstörung signifikant reduziert. Eine Lösung dieses Problems besteht darin, Hörgeräte mit Kompression zu verwenden. Die Kompression in Hörgeräten hat die Aufgabe, den Dynamikbereich der Normalhörenden in denjenigen der Schwerhörigen zu transferieren. Dabei geht es insbesondere darum, leise Signale in den hörbaren Bereich zu verschieben, aber laute Signale nicht weiter zu verstärken. Problematisch hierbei sind dynamische Schwankungen.

Der Erhalt oder die Verbesserung der Sprachverständlichkeit beim Tragen von Hörgeräten ist meist vorrangiges Ziel. Daher besteht eine große Herausforderung darin, gerade für den Typ des Sprachsignals eine geeignete Reduktion des Dynamikbereichs zu finden. Die Problematik hierbei liegt insbesondere in den zeitlichen Schwankungen von Sprachpegeln. Dabei sind sowohl langsame Sprachpegeländerungen, die die Variationen des Gesamtsprachpegels wiedergeben, und die schnellen Sprachpegeländerungen, die die Pegeldifferenzen zwischen Sprachkomponenten (Vokalen, Konsonanten, Phonemen) wiedergeben, von Bedeutung.

Aus der Offenlegungsschrift DE 10 2005 061 000 A1 ist eine Signalverarbeitung von Hörgeräten bekannt, bei der ein Eingangssignal hinsichtlich der aktuellen Hörsituation klassifiziert wird. Abhängig von dem Klassifizierungsergebnis wird das Eingangssignal entsprechend einem ersten Kompressionsalgorithmus oder einem zweiten Kompressionsalgorithmus verstärkt.

Einige bekannte Kompressionsstrategien mit langsamen Zeitkonstanten zielen darauf ab, die schnellen zeitlichen Pegelfluktuationen zwischen Vokalen und Konsonanten zu erhalten. Die leisen Teile der Sprache (insbesondere zwischen Vokalen) werden dadurch oftmals unhörbar oder mit dieser Art der Kompression einfach zu leise.

Die Aufgabe der vorliegenden Erfindung besteht somit darin, auch leise Teile der Sprache hörbar zu machen, ohne den Gesamtpegel des Sprachsignals wesentlich anzuheben.

Erfindungsgemäß wird diese Aufgabe gelöst durch ein Verfahren zum Verstärken eines Sprachsignals für eine Hörvorrichtung durch Erfassen eines Eingangsschalls durch die Hörvorrichtung, Ermitteln eines Eingangspegels des Eingangsschalls und Verstärken des Eingangsschalls durch die Hörvorrichtung, wobei ein durchschnittlicher breitbandiger Eingangspegel des Eingangsschalls ermittelt wird, festgestellt wird, ob der Eingangsschall einen Sprachanteil aufweist, und falls nein, das Verstärken des Eingangssignals in Abhängigkeit von dem Eingangspegel gemäß einer vorgegebenen ersten Verstärkungskennlinie erfolgt, falls ja, das Verstärken des Eingangssignals in Abhängigkeit von dem Eingangspegel gemäß einer vorgegebenen zweiten Verstärkungskennlinie erfolgt, wobei die zweite Verstärkungskennlinie in Abhängigkeit von dem durchschnittlichen breitbandigen Eingangspegel so gebildet wird, dass in einem vorgegebenen Pegelabstand unterhalb des durchschnittlichen breitbandigen Eingangspegels die Verstärkung gegenüber der ersten Verstärkungskennlinie angehoben ist. Dabei stellt eine Verstärkungskennlinie die Funktion der Verstärkung über dem Eingangspegel dar. Unter "breitbandig" wird hier die gesamte spektrale Bandbreite der Signalverarbeitung der Hörvorrichtung verstanden.

Darüber hinaus wird erfindungsgemäß bereitgestellt eine Hörvorrichtung mit einer Erfassungseinrichtung zum Erfassen eines Eingangsschalls, einer Messeinrichtung zum Ermitteln eines Eingangspegels des Eingangsschalls und einer Verstärkungseinrichtung zum Verstärken des Eingangsschalls, wobei durch die Messeinrichtung ein durchschnittlicher breitbandiger Eingangspegel des Eingangsschalls ermittelbar ist, von einer Klassifikationseinrichtung der Hörvorrichtung feststellbar ist, ob der Eingangsschall einen Sprachanteil aufweist, und die Verstärkungseinrichtung von der Klassifikationseinrichtung so steuerbar ist, dass das Verstärken des Eingangssignals in Abhängigkeit von dem Eingangspegel gemäß einer vorgegebenen ersten Verstärkungskennlinie erfolgt, falls kein Sprachanteil in dem Eingangssignal festgestellt ist, und das Verstärken des Eingangssignals in Abhängigkeit von dem Eingangspegel gemäß einer vorgegebenen zweiten Verstärkungskennlinie erfolgt, falls ein Sprachanteil in dem Eingangssignal festgestellt ist, wobei die zweite Verstärkungskennlinie in Abhängigkeit von dem durchschnittlichen breitbandigen Eingangspegel so gebildet ist, dass in einem vorgegebenen Pegelabstand unterhalb des durchschnittlichen breitbandigen Eingangspegels die Verstärkung gegenüber der ersten Verstärkungskennlinie angehoben ist.

In vorteilhafter Weise erfolgt also eine adaptive Überhöhung von Sprachsignalen in Abhängigkeit vom Eingangspegel. Dies wird dadurch erreicht, dass die Verstärkung in einem vorbestimmten Bereich unterhalb des durchschnittlichen breitbandigen aktuellen Eingangspegels, der in etwa den Pegel von Vokalen entspricht, bei einem detektierten Sprachsignal höher ist als in dem Fall, dass kein Sprachsignal detektiert wird. Dadurch lassen sich insbesondere die Pegel von Konsonanten anheben, sodass insgesamt die Sprachverständlichkeit deutlich steigt.

Vorzugsweise ist der vorgegebene Pegelabstand ein durchschnittlicher Abstand zwischen einem Vokalpegel und einem Konsonantenpegel am Eingang. Dabei ist der Vokalpegel derjenige Pegel, der bei einem aktuellen Sprachsignal durchschnittlich bei Vokalen gemessen werden kann. Der Konsonantenpegel ist derjenige Pegel, der bei der aktuellen Sprache bei Konsonanten durchschnittlich gemessen wird. Da der Vokalpegel im Wesentlichen dem Gesamtsprachpegel entspricht und damit leicht zu messen ist, kann der Konsonantenpegel mit dem bekannten Pegelabstand leicht aus dem gemessenen Vokalpegel ermittelt werden. Der durchschnittliche Abstand zwischen Vokalpegel und Konsonantenpegel ist für durchschnittliche Sprecher bei lauter und leiser Sprache nämlich bekannt.

Die zweite Verstärkungskennlinie kann in einem Pegelbereich vorgegebener Breite über der ersten Verstärkungskennlinie liegen. Dies bedeutet, dass die zweite Verstärkungskennlinie nicht nur bei einem festen Eingangspegel über der ersten Verstärkungskennlinie liegt, sondern in einem größeren Bereich von Eingangspegeln. Dieser Bereich von Eingangspegeln sollte den wesentlichen Pegelbereich der Konsonanten abdecken. Vorzugsweise liegt die vorgegebene Breite etwa in der Größenordnung des vorgegebenen Pegelabstands. Entspricht die vorgegebene Breite in etwa dem Pegelabstand zwischen Konsonanten und Vokalen und findet die Überhöhung in etwa symmetrisch zu dem mittleren Konsonantenpegel statt, so reicht der Bereich der Überhöhung in etwa bis zur Mitte zwischen Konsonantenpegel und Vokalpegel.

Die Werte der zweiten Verstärkungskennlinie liegen vorteilhafterweise maximal 12 dB bis 24 dB über denen der ersten Verstärkungskennlinie. Mit dieser Überhöhung zwischen 12 und 24 dB maximal kann die Sprachverständlichkeit am besten erhöht werden.

Günstigerweise wird das Verfahren ausschließlich für Schallanteile des Eingangsschalls mit Frequenzen oberhalb einer vorgegebenen Frequenz, z. B 1500 Hz, insbesondere oberhalb von 3000 Hz, angewandt. Dies liegt daran, dass Konsonanten wesentliche Frequenzanteile oberhalb von 1500 Hz besitzen. Hinsichtlich der Sprachverständlichkeit genügt es im Wesentlichen, wenn Frequenzanteile über 3000 Hz mit dem erfindungsgemäßen Verfahren überhöht werden.

Die zweite Verstärkungskennlinie kann gegenüber der ersten Verstärkungskennlinie in verschiedenen Frequenzbändern unterschiedlich angehoben werden. Damit erfolgt die Überhöhung der Sprachsignalanteile nicht nur eingangspegelabhängig, sondern auch frequenzabhängig. Dies erhöht nicht nur die Sprachverständlichkeit, sondern es bleibt dadurch auch der natürliche Klangeindruck besser erhalten.

Darüber hinaus ist es vorteilhaft, wenn das Verstärken in einem ersten und einem dazu parallelen zweiten Pfad der Hörvorrichtung ausgeführt wird, in dem ersten Pfad eine erste Kompression und in den zweiten Pfad eine zweite Kompression durchgeführt wird, die zweite Kompression stärker als die erste Kompression ist, und in den zweiten Pfad die Verstärkung entsprechend der ersten und zweiten Verstärkungskennlinie erfolgt. Durch die Überlagerung von zwei verschiedenen Kompressionskennlinien kann eine vorteilhafte, nicht lineare Kompression erzielt werden. Speziell können die Signale des ersten und zweiten Pfads mit einem Mischverhältnis gemischt werden, das von dem Eingangspegel des Eingangsschalls abhängt. Damit kann die Kompression dynamisch an den aktuellen Eingangsschall angepasst werden. Gleichzeitig lässt sich bei Verwendung der verschiedenen Verstärkungskennlinien für Sprachsignale und nicht-Sprachsignale die Sprachverständlichkeit erhöhen.

Die vorliegende Erfindung wird anhand der beigefügten Zeichnungen näher erläutert, in denen zeigen:
- FIG 1: den schematischen Aufbau eines Hörgeräts gemäß dem Stand der Technik;
- FIG 2: ein Diagramm einer Verstärkungskennlinie über dem Eingangspegel bei einer ersten Sprache;
- FIG 3: eine Verstärkungskennlinie über dem Eingangspegel bei einer zweiten Sprache;
- FIG 4: eine parallele Kompression in Abhängigkeit von einem mittleren Eingangspegel in einem Hörgerät und;
- FIG 5: ein elektrisches Schaltschema zur Realisierung einer parallelen Kompression.

Die nachfolgend näher geschilderten Ausführungsbeispiele stellen bevorzugte Ausführungsformen der vorliegenden Erfindung dar.

Es hat sich gezeigt, dass die Sprachverständlichkeit unter anderem von dem Verhältnis des Konsonantenpegels zu dem Vokalpegel in dem Sprachsignal eines individuellen Sprechers abhängt. Dabei bedeutet der Konsonantenpegel der mittlere Pegel von Konsonanten und der Vokalpegel der mittlere Pegel von Vokalen in einer Sprache. Die Sprachverständlichkeit kann durch Erhöhung des Konsonantenpegels, d. h. des Pegels der Konsonanten, ohne gleichzeitige Erhöhung des Vokalpegels (Referenzpegel) verbessert werden. Die auf diese Weise erzielte Verbesserung der Sprachverständlichkeit ist dann am höchsten, wenn das Konsonanten-Vokal-Verhältnis (CVR; d. h. Abstand zwischen dem Konsonantenpegel und dem Vokalpegel) höher als bei durchschnittlicher Sprache ist. Besonders gute Ergebnisse hinsichtlich der Sprachverständlichkeit haben sich ergeben, wenn der Konsonantenpegel gegenüber dem Vokalpegel um bis zu 12 bis 24 dB überhöht bzw. angehoben wird. Dies bringt insbesondere Vorteile bei Konsonanten im höheren Frequenzspektrum, d. h. oberhalb von 1500 Hz und insbesondere oberhalb von 3000 Hz. Davon betroffen sind in erster Linie Reiblaute ("s", "sch", "f" etc.) und sogenannte Stop-Konsonanten ("p", "t" etc.).

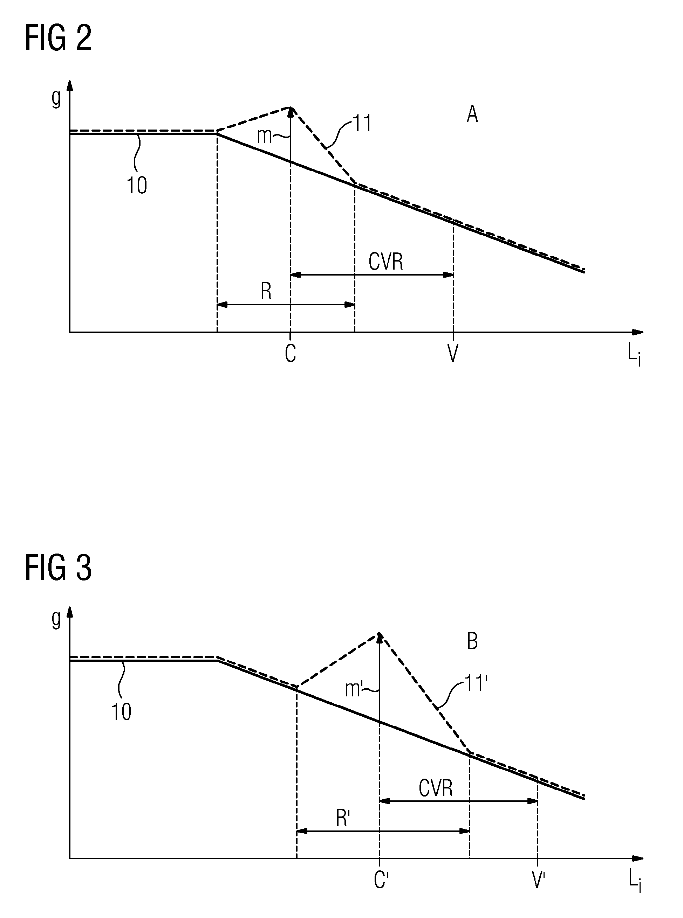

Um von diesen Kenntnissen profitieren zu können, muss eine spezielle Kompressionsstrategie angewandt werden, die zusätzlich zu der "normalen" Kompression durchgeführt wird. Eine derartige Strategie kann anhand von FIG 2 für eine erste Sprache A erläutert werden. Dazu muss die Hörvorrichtung bzw. das Hörgerät einen Klassifizierer oder eine ähnliche Einrichtung aufweisen, die feststellen kann, ob der Eingangsschall einen Sprachanteil besitzt oder nicht. Wenn kein Sprachanteil in dem Eingangsschall detektiert wird, erfolgt eine pegelabhängige Verstärkung gemäß einer ersten Verstärkungskennlinie 10 (in FIG 2 als durchgezogene Linie dargestellt). Es ist zu erkennen, dass die Verstärkung g von dem Eingangspegel Lᵢ des Eingangsschalls abhängt. Wird hingegen ein Sprachanteil in dem Eingangsschall festgestellt, so erfolgt die pegelabhängige Verstärkung entsprechend einer zweiten Verstärkungskennlinie 11. Diese liegt teilweise auf der ersten Verstärkungskennlinie 10 und teilweise darüber.

Die zweite Verstärkungskennlinie wird stets an die aktuelle Sprache A (vergleiche FIG 2) oder B (vergleiche FIG 3) angepasst. Dazu wird in einem ersten Schritt der gesamte Sprachpegel der aktuellen Sprache A bzw. B breitbandig (gesamte Verarbeitungsbandbreite) gemessen. Dieser Gesamtsprachpegel, der hier auch als durchschnittlicher breitbandiger Eingangspegel bezeichnet wird, wird von dem Vokalpegel V dominiert. Dies bedeutet, dass der Gesamtsprachpegel in erster Linie von der Lautstärke der Vokale abhängt. Weiterhin ist das Verhältnis der Lautstärken von Konsonanten zu Vokalen (CVR) bekannt. Dieses Verhältnis CVR entspricht dem Abstand zwischen dem Vokalpegel V und dem Konsonantenpegel C. Das Verhältnis CVR kann durch mehrere Messungen und Durchschnittsbildung ermittelt werden. Somit lässt sich der Konsonantenpegel C einfach von dem Gesamtsignalpegel, der etwa dem Vokalpegel entspricht, ableiten, indem nämlich ein Standard- bzw. durchschnittlicher CVR von dem gemessenen Gesamtsprachpegel subtrahiert wird. Je nach gemessenem Gesamtsprachpegel bzw. Vokalpegel ergibt sich für die aktuelle Sprache dann ein aktueller deutlich niedrigerer Konsonantenpegel C. In dem Beispiel von FIG 2 wird also für die Sprache A der Vokalpegel V gemessen, und der Konsonantenpegel C liegt in einem Abstand CVR darunter. In dem Beispiel von FIG 3 wird für die Sprache B der aktuelle Gesamtsprachpegel bzw. Vokalpegel V' gemessen, sodass sich abzüglich des Standard-CVR der Konsonantenpegel C' ergibt.

Die Verstärkung g wird nun bei dem ermittelten Konsonantenpegel C bzw. C' gegenüber der ersten Verstärkungskennlinie 10 erhöht. Die Verstärkung wird aber nicht nur exakt bei dem Wert C bzw. C' des Eingangspegels Lᵢ erhöht, sondern jeweils in einem Bereich R bzw. R' um den jeweiligen Wert C bzw. C'. Mit dieser Überhöhung ergibt sich dann die jeweilige zweite Verstärkungskennlinie 11 bzw. 11', die zumindest bereichsweise (in den Bereichen R und R') über der ersten Verstärkungskennlinie 10 liegt.

Vorzugsweise verläuft die erste Verstärkungskennlinie 10 wie auch die zweite Verstärkungskennlinie 11, 11' stetig. D. h. sie weist keine Sprünge auf. Dabei können die Verstärkungskennlinien aus linearen Abschnitten zusammengesetzt sein wie in den Beispielen von FIG 2 und FIG 3. Die Verstärkungskennlinien können aber auch nicht lineare Verläufe aufweisen. Die jeweiligen Verläufe in den Verstärkungskennlinien können durch Standard-Expansionsmethoden und Standard-Kompressionsmethoden erreicht werden.

In den Beispielen der FIG 2 und 3 wird eine maximale Überhöhung m bzw. m' bei dem Eingangspegel C bzw. C' durchgeführt, also bei dem rechnerisch ermittelten Konsonantenpegel. Diese maximale Überhöhung sollte zwischen 12 und 24 dB liegen. Bei diesen Überhöhungswerten lassen sich die besten Ergebnisse hinsichtlich Sprachverständlichkeit erzielen. Die maximalen Überhöhungen müssen aber nicht exakt bei C bzw. C' liegen. Auch muss der jeweilige Überhöhungsbereich bezüglich C oder C' nicht symmetrisch sein. Wesentlich ist nur, das C bzw. C' in dem Überhöhungsbereich R bzw. R' liegt.

Die Kompressionsüberhöhung sollte nur bei hochfrequenten Sprachanteilen über 1500 Hz und insbesondere über 3000 Hz angewandt werden. Dies betrifft also sogenannte hochfrequente Konsonanten, deren wesentliche Frequenzanteile oberhalb der genannten Frequenzen liegen. Speziell sind dies Reiblaute und Stop-Konsonanten.

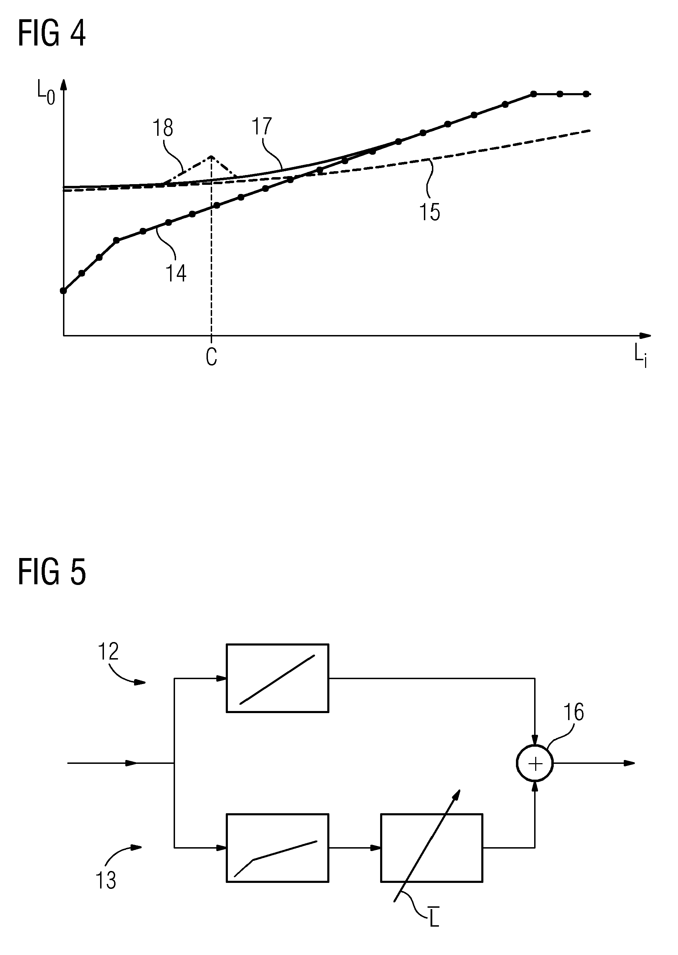

Wie anhand der FIG 4 und 5 erläutert wird, lässt sich die Überhöhung der Verstärkung bei den Konsonantenpegeln C und C' mit der sogenannten parallelen Kompression verknüpfen. Mit dieser parallelen Kompression lässt sich das Problem einer einfachen Kompression, die entweder sehr langsam oder sehr schnell arbeitet beheben. Bei sehr langsam nachgeregelter Verstärkung ist es nämlich nicht möglich, sehr leise Details zu verstärken, ohne zu viel Verstärkung für lautere Signale anzubieten. Arbeitet die Regelung dagegen sehr schnell, werden leise Details hörbar. Der Klang leidet aber insgesamt sehr stark, da die Dynamik natürlicher Signale vollständig verloren geht. Bei der parallelen Kompression hingegen wird das Signal auf zwei Kanäle 12, 13 aufgespaltet. Der eine Kanal 13 komprimiert das Signal entsprechend einer Kompressionskennlinie 14 sehr moderat und sehr langsam, um in erster Linie zu laute Ausgangsgrößen zu vermeiden. Der andere, parallele Kanal 12 komprimiert das Eingangssignal gemäß einer Kompressionskennlinie 15 sehr stark und sehr schnell. Am Ende werden die Signale beider Pfade 12, 13 in einem Addierer 16 wieder addiert. Das Mischungsverhältnis beider Kanäle 12, 13 wird abhängig von einem zeitlich gemittelten, mittleren Eingangspegel *L̅* bestimmt. Ziel des adaptiven Mischens ist es, bei sehr leisen Umgebungen möglichst wenig zu komprimieren bei lauten Pegeln allerdings eher viel. So wird vermieden, dass leise Störgeräusche aus der Umgebung in der Stille zu stark verstärkt werden. Insgesamt ergibt sich dann eine resultierende Kompressionskennlinie 17, die beispielsweise bei niedrigen Eingangspegeln von der schnellen Kompression 15 und bei höheren Eingangspegeln von der langsamen Kompression 14 dominiert wird.

Ziel dieser Kompressionsmethode ist es, die Klangqualität des Eingangssignals soweit wie möglich trotz hoher und schneller Kompression zu erhalten. Die Klarheit eines Signals hängt im hohen Maße von Impulsen ab, die das Klangbild strukturieren. Eine herkömmliche, schnelle Kompression verschleift diese Impulse. Der Ansatz der parallelen Kompression kann so parametriert werden, das die lauteren Impulse stets unkomprimiert dem Ausgangssignal zugemischt werden, während leise Details über den anderen Kanal zugemischt werden können. Die darin enthaltenen komprimierten Impulse werden von denen in den unkomprimierten oder sehr langsamen Kanal überdeckt. Durch die Abhängigkeit des Mischungsverhältnisses vom mittleren Eingangspegel kann genau diese Parametrierung leicht erreicht werden.

Falls nun Sprache im Eingangssignal detektiert wird, kann die Kompressionskennlinie 15 für die schnelle Kompression durch eine Kompressionskennlinie ersetzt werden, die auf der zweiten Verstärkungskennlinie 11 bzw. 11' (vergleiche FIG 2 und 3) beruht. Damit ergäbe sich eine zusätzliche Überhöhung im Bereich C des Eingangspegels Lᵢ. Eine derartige zusätzliche Überhöhung 18 ist in FIG 4 durch eine Strichpunktlinie symbolisiert. Diese Überhöhung 18 wäre bei Sprachanteilen Teil der resultierenden Kompressionskennlinie 17.

Die angeführten Ausführungsbeispiele besitzen den Vorteil, dass durch den Einsatz des bekannten Abstands CVR auf einfache Weise spezifisch die Verstärkung von Konsonanten bei der Kompression erhöht werden kann, sodass sich letztlich die Sprachverständlichkeit verbessern lässt. Außerdem erfolgt bei der Kompression eine Adaption an den aktuellen Gesamtpegel der Sprache. Dabei kann der Abstand CVR z. B. für eine leise, eine mittlere und eine laute Sprache vorgegeben werden. Darüber hinaus erfolgt keine abrupte Erhöhung der Konsonantenpegel, sondern ein weicher Übergang. Ein abrupter Übergang der Verstärkung würde den negativen Effekt haben, dass Umgebungsstörgeräusche übermäßig verstärkt werden. Der weiche Übergang hingegen glättet die Schallqualität und macht das Verfahren robuster gegen andere Störgeräusche.

## Patentansprüche

1. Verfahren zum Verstärken eines Sprachsignals für eine Hörvorrichtung durch
- Erfassen eines Eingangsschalls durch die Hörvorrichtung,
- Ermitteln eines Eingangspegels (Lᵢ) des Eingangsschalls und
- Verstärken des Eingangsschalls durch die Hörvorrichtung, wobei
- ein durchschnittlicher breitbandiger Eingangspegel (V, V') des Eingangsschalls ermittelt wird,
- festgestellt wird, ob der Eingangsschall einen Sprachanteil aufweist, und
- falls nein, das Verstärken des Eingangssignals in Abhängigkeit von dem Eingangspegel gemäß einer vorgegebenen ersten Verstärkungskennlinie (10) erfolgt,
- falls ja, das Verstärken des Eingangssignals in Abhängigkeit von dem Eingangspegel (Lᵢ) gemäß einer vorgegebenen zweiten Verstärkungskennlinie (11, 11') erfolgt,
**dadurch gekennzeichnet, dass**
die zweite Verstärkungskennlinie in Abhängigkeit von dem durchschnittlichen breitbandigen Eingangspegel (V) so gebildet wird, dass in einem vorgegebenen Pegelabstand (CVR) unterhalb des durchschnittlichen breitbandigen Eingangspegels (V) die Verstärkung (g) gegenüber der ersten Verstärkungskennlinie (10) angehoben ist, wobei der vorgegebene Pegelabstand (CVR) ein durchschnittlicher Abstand zwischen einem Vokalpegel und einem Konsonantenpegel (C) ist und
wobei die zweite Verstärkungskennlinie (11, 11') in einem Pegelbereich vorgegebener Breite (R, R') über der ersten Verstärkungskennlinie (10) liegt.

2. Verfahren nach Anspruch 1,
wobei die vorgegebene Breite (R, R') in der Größenordnung des vorgegebenen Pegelabstands (CVR) liegt.

3. Verfahren nach einem der vorhergehenden Ansprüche,
wobei die Werte der zweiten Verstärkungskennlinie (11, 11') um maximal 12 dB bis 24 dB über denen der ersten Verstärkungskennlinie (10) liegen.

4. Verfahren nach einem der vorhergehenden Ansprüche,
das ausschließlich für Schallanteile des Eingangsschalls mit Frequenzen oberhalb einer vorgegebenen Frequenz angewandt wird.

5. Verfahren nach einem der vorhergehenden Ansprüche,
wobei die zweite Verstärkungskennlinie (11, 11') gegenüber der ersten Verstärkungskennlinie (10) in verschiedenen Frequenzbändern unterschiedlich angehoben ist.

6. Verfahren nach einem der vorhergehenden Ansprüche,
wobei das Verstärken in einem ersten (12) und einem dazu parallelen zweiten Pfad (13) der Hörvorrichtung ausgeführt wird, in dem ersten Pfad (12) eine erste Kompression und in dem zweiten Pfad eine zweite Kompression durchgeführt wird, die zweite Kompression stärker als die erste Kompression ist, und in dem zweiten Pfad (13)die Verstärkung entsprechend der ersten bzw. zweiten Verstärkungskennlinie (10, 11, 11') erfolgt.

7. Verfahren nach Anspruch 6,
wobei Signale des ersten und zweiten Pfads (12, 13) mit einem Mischungsverhältnis gemischt werden, das von dem Eingangspegel (Lᵢ) des Eingangsschalls abhängt.

8. Hörvorrichtung mit
- einer Erfassungseinrichtung zum Erfassen eines Eingangsschalls,
- einer Messeinrichtung zum Ermitteln eines Eingangspegels (Lᵢ) des Eingangsschalls und
- einer Verstärkungseinrichtung zum Verstärken des Eingangsschalls,
wobei
- durch die Messeinrichtung ein durchschnittlicher breitbandiger Eingangspegel (V) des Eingangsschalls ermittelbar ist,
- von einer Klassifikationseinrichtung der Hörvorrichtung feststellbar ist, ob der Eingangsschall einen Sprachanteil aufweist,
**dadurch gekennzeichnet, dass**
- die Verstärkungseinrichtung von der Klassifikationseinrichtung so gesteuert wird, dass
∘ das Verstärken des Eingangssignals in Abhängigkeit von dem Eingangspegel (Lᵢ) gemäß einer vorgegebenen ersten Verstärkungskennlinie (10) erfolgt, falls kein Sprachanteil in dem Eingangssignal festgestellt ist, und
∘ das Verstärken des Eingangssignals in Abhängigkeit von dem Eingangspegel (Lᵢ) gemäß einer vorgegebenen zweiten Verstärkungskennlinie (11, 11') erfolgt, falls ein Sprachanteil in dem Eingangssignal festgestellt ist, wobei die zweite Verstärkungskennlinie in Abhängigkeit von dem durchschnittlichen breitbandigen Eingangspegel (V) so gebildet ist, dass in einem vorgegebenen Pegelabstand (CVR) unterhalb des durchschnittlichen breitbandigen Eingangspegels (V) die Verstärkung (g) gegenüber der ersten Verstärkungskennlinie (10) angehoben ist,
wobei der vorgegebene Pegelabstand (CVR) ein durchschnittlicher Abstand zwischen einem Vokalpegel und einem Konsonantenpegel (C) ist und
wobei die zweite Verstärkungskennlinie (11, 11') in einem Pegelbereich vorgegebener Breite (R, R') über der ersten Verstärkungskennlinie (10) liegt.

## Claims

1. Method for amplifying a speech signal for a hearing apparatus by
- detection of an input sound by the hearing apparatus,
- determination of an input level (Lᵢ) of the input sound and
- amplification of the input sound by the hearing apparatus, wherein
- a mean broadband input level (V, V') of the input sound is determined,
- it is established whether the input sound has a speech component, and
- if not, the input signal is amplified as a function of the input level in accordance with a predefined first amplification characteristic (10),
- if so, the input signal is amplified as a function of the input level (Lᵢ) in accordance with a predefined second amplification characteristic (11, 11'),
**characterised in that**
the second amplification characteristic is formed as a function of the mean broadband input level (V) such that amplification (g) is increased with respect to the first amplification characteristic (10) in a predefined level interval (CVR) below the mean broadband input level (V), wherein the predefined level interval (CVR) is a mean interval between a vowel level and a consonant level (C) and
wherein the second amplification characteristic (11, 11') lies in a level range of predefined breadth (R, R') above the first amplification characteristic (10).

2. Method according to claim 1,
wherein the predefined breadth (R, R') is in the order of magnitude of the predefined level interval (CVR).

3. Method according to any one of the preceding claims,
wherein the values of the second amplification characteristic (11, 11') are a maximum of 12 dB to 24 dB above those of the first amplification characteristic (10).

4. Method according to any one of the preceding claims,
which is applied solely to sound components of the input sound having frequencies above a predefined frequency.

5. Method according to any one of the preceding claims,
wherein the second amplification characteristic (11, 11') is increased differently with respect to the first amplification characteristic (10) in various frequency bands.

6. Method according to any one of the preceding claims,
wherein amplification is performed in a first (12) and a second path (13), parallel thereto, of the hearing apparatus, a first compression is performed in the first path (12) and a second compression is performed in the second path, the second compression is greater than the first compression, and amplification is carried out in the second path (13) in accordance with the first or second amplification characteristic (10, 11, 11').

7. Method according to claim 6,
wherein signals of the first and second paths (12, 13) are mixed with a mixing ratio which depends on the input level (Lᵢ) of the input sound.

8. Hearing apparatus having
- a detection device for detecting an input sound,
- a measuring device for determining an input level (Lᵢ) of the input sound and
- an amplification device for amplifying the input sound, wherein
- a mean broadband input level (V) of the input sound can be determined by the measuring device,
- it can be established by a classification device of the hearing apparatus whether the input sound has a speech component,
**characterised in that**
- the amplification device is controlled by the classification device in such a way that
∘ the input signal is amplified as a function of the input level (Lᵢ) in accordance with a predefined first amplification characteristic (10) if no speech component is found in the input signal, and
∘ the input signal is amplified as a function of the input level (Lᵢ) in accordance with a predefined second amplification characteristic (11, 11') if a speech component is found in the input signal, wherein the second amplification characteristic is formed as a function of the mean broadband input level (V) such that amplification (g) is increased with respect to the first amplification characteristic (10) in a predefined level interval (CVR) below the mean broadband input level (V),
wherein the predefined level interval (CVR) is a mean interval between a vowel level and a consonant level (C) and
wherein the second amplification characteristic (11, 11') lies in a level range of predefined breadth (R, R') above the first amplification characteristic (10).

## Revendications

1. Procédé d'amplification d'un signal vocal pour une prothèse auditive par
- détection d'un son d'entrée par la prothèse auditive,
- détermination d'un niveau ( Lᵢ ) d'entrée du son d'entrée et
- amplification du son d'entrée par la prothèse auditive,
dans lequel
- on détermine un niveau ( V, V' ) d'entrée moyen à bande large du son d'entrée,
- on constate si le son d'entrée a une partie vocale, et
- si ce n'est pas le cas, on effectue l'amplification du signal d'entrée en fonction du niveau d'entrée suivant une première courbe ( 10 ) caractéristique d'amplification donnée à l'avance,
- si c'est le cas, on effectue l'amplification du signal d'entrée en fonction du niveau ( Lᵢ ) d'entrée suivant une deuxième courbe ( 11, 11' ) caractéristique d'amplification donnée à l'avance,
**caractérisé en ce que**
la deuxième courbe caractéristique d'amplification est formée en fonction du niveau ( V ) d'entrée moyen à bande large, de manière à ce que, à une distance ( CVR ) de niveau donnée à l'avance en dessous du niveau ( V ) d'entrée moyen à bande large, l'amplification ( g ) soit surélevée par rapport à la première courbe ( 10 ) caractéristique d'amplification, la distance ( CVR ) de niveau donnée à l'avance étant une distance moyenne entre un niveau de voyelle et un niveau ( C ) de consonne et
dans lequel la deuxième courbe ( 11, 11' ) caractéristique d'amplification se trouve dans une plage de niveau de largeur ( R, R' ) donnée à l'avance au-dessus de la première courbe ( 10 ) caractéristique d'amplification.

2. Procédé suivant la revendication 1,
dans lequel la largeur ( R, R' ) donnée à l'avance est de l'ordre de grandeur de la distance ( CVR ) de niveau donnée à l'avance.

3. Procédé suivant l'une des revendications précédentes,
dans lequel les valeurs de la deuxième courbe ( 11, 11' ) caractéristique d'amplification sont au maximum de 12 dB à 24 dB au-dessus de celles de la première courbe ( 10 ) caractéristique d'amplification.

4. Procédé suivant l'une des revendications précédentes,
qui est appliqué exclusivement pour les parties du son d'entrée ayant une fréquence supérieure à une fréquence donnée à l'avance.

5. Procédé suivant l'une des revendications précédentes,
dans lequel la deuxième courbe ( 11, 11' ) caractéristique d'amplification est surélevée différemment par rapport à la première courbe ( 10 ) caractéristique d'amplification dans des bandes de fréquence différentes.

6. Procédé suivant l'une des revendications précédentes,
dans lequel l'amplification est réalisée dans un premier ( 12 ) et dans un deuxième ( 13 ) trajets parallèles de la prothèse auditive, une première compression étant effectuée dans le premier trajet ( 12 ) et une deuxième compression dans le deuxième trajet, la deuxième compression étant plus forte que la première compression, et, dans le deuxième trajet
( 13 ), l'amplification s'effectue conformément à la première ou à la deuxième courbe ( 10, 11, 11' ) caractéristique d'amplification.

7. Procédé suivant la revendication 6,
dans lequel on mélange des signaux du premier et du deuxième trajets ( 12, 13 ) en un rapport de mélange, qui dépend du niveau ( Lᵢ ) d'entrée du son d'entrée.

8. Prothèse auditive comprenant
- un dispositif de détection pour la détection d'un son d'entrée,
- un dispositif de mesure pour la détermination d'un niveau ( Lᵢ ) d'entrée du son d'entrée et
- un dispositif d'amplification pour l'amplification du son d'entrée,
dans laquelle
- un niveau ( V ) d'entrée moyen à bande large du son d'entrée peut être déterminé par le dispositif de mesure,
- il peut être constaté, par un dispositif de classification de la prothèse auditive, si le son d'entrée à une partie vocale,
**caractérisée en ce que**
- le dispositif d'amplification est commandé par le dispositif de classification, de manière à ce que
∘ l'amplification du signal d'entrée s'effectue en fonction du niveau ( Lᵢ ) d'entrée suivant une première courbe ( 10 ) caractéristique d'amplification donnée à l'avance, s'il n'est pas constaté de partie vocale dans le signal d'entrée, et
∘ l'amplification du signal d'entrée s'effectue en fonction du niveau ( Lᵢ ) d'entrée suivant une deuxième courbe ( 11, 11' ) caractéristique d'amplification donnée à l'avance, s'il est constaté une partie vocale dans le signal d'entrée, la deuxième courbe caractéristique d'amplification étant formée en fonction du niveau ( V ) d'entrée moyen à bande large, de manière à ce que, à une distance ( CVR ) de niveau donnée à l'avance, en dessous du niveau ( V ) d'entrée moyen à bande large, l'amplification ( g ) soit surélevée par rapport à la premier courbe ( 10 ) caractéristique d'amplification,
dans laquelle la distance ( CVR ) de niveau donnée à l'avance est une distance moyenne entre un niveau de voyelle et un niveau ( C ) de consonne et
dans laquelle la deuxième courbe ( 11, 11' ) caractéristique d'amplification se trouve dans une plage de niveau de largeur ( R, R' ) donnée à l'avance au-dessus de la première courbe ( 10 ) caractéristique d'amplification.
